# FASCICULE DE BREVET EUROPEEN

(11) **EP 1 361 451 B1**
(45) Date de publication et mention de la délivrance du brevet: **14.01.2009**
(21) Numéro de dépôt: 03101237.0
(22) Date de dépôt: 05.05.2003
(51) Int. Cl.: G01R 31/319

(54) **Plaquette de test pour le contrôle de dispositifs microélectroniques et appareil de contrôle utilisant cette plaquette de test**
Kontaktor zur Inspektion von mikroelektronischen Anordnungen und Inspektionsvorrichtung mit solchem Kontaktor
Contacting piece for the inspection of microlectronic devices and inspection device using this contact piece

(30) Priorité: 07.05.2002 FR 0205717
(43) Date de publication de la demande: 12.11.2003
(73) Titulaire: COMMISSARIAT A L'ENERGIE ATOMIQUE, 75015 Paris (FR)
(72) Inventeur: TOFFOLI, Alain, 38450, VIF (FR); PARAT, Guy, 38640, CLAIX (FR)
(74) Mandataire: Poulin, Gérard

(56) Documents cités:
- US-A- 3 848 188
- US-A- 5 034 685

## Description

### DOMAINE TECHNIQUE

L'invention concerne une plaquette de test pour le contrôle de dispositifs microélectroniques. Elle concerne également un appareil de contrôle utilisant cette plaquette de test. Elle se rapporte au domaine du test électrique des dispositifs électroniques ou technologiques réalisés en technique microélectronique : les circuits intégrés, les capteurs, les dispositifs élémentaires (résistances, diodes, condensateurs, ...)

### ETAT DE LA TECHNIQUE ANTERIEURE

Les dispositifs électroniques comme par exemple des circuits intégrés, des capteurs, des composants élémentaires sont réalisés sur des plaquettes généralement en silicium. Ces dispositifs sont ensuite contrôlés sur des bancs spécifiques comportant :
- un système de test, généralement composé d'un ensemble d'appareils aptes à effectuer des mesures analogiques et/ou numériques,
- une carte à pointes dont le but est d'assurer les connexions électriques entre le système de test et les plots de contact du dispositif électronique réalisé sur la plaquette de silicium,
- un robot chargé de manipuler les plaquettes, pour les mettre successivement sous la carte à pointes, et de déplacer la plaquette qui est mise sous la carte à pointes pour tester successivement tous les composants (puces ou dispositifs électroniques) réalisés sur la plaquette,
- un micro-ordinateur pour gérer la réalisation automatique des tests.

Cette technique présente différents inconvénients. Un premier inconvénient est constitué par le temps de test d'une plaquette. Celui-ci est directement lié au nombre de composants présents sur la plaquette puisque les composants sont testés successivement.

Un deuxième inconvénient résulte de la carte à pointes qui fait appel à des techniques de pointes classiques (pointes soudées sur un support époxy) ou de cartes à membranes (croissance de bosses sur un substrat). Dans les deux cas, ces cartes sont de plus en plus coûteuses et lourdes à mettre en oeuvre, surtout lorsque le nombre de plots de connexion augmente.

Un troisième inconvénient provient des robots de manipulation qui sont de plus en plus encombrants puisqu'ils sont destinés à manipuler des plaquettes de taille de plus en plus grande. La taille des plaquettes augmentant, la surface de déplacement de la plaquette sous la carte à pointes doit être au moins quatre fois plus grande que la taille de la plaquette pour pouvoir tester tous les composants.

Un quatrième inconvénient provient de l'utilisation ou de l'immobilisation du banc de test pour contrôler, en cours ou en fin de fabrication, des composants simples (par exemple des résistances ou des diodes) surtout dans les nouvelles techniques de micro-technologie.

Un cinquième inconvénient résulte de la difficulté de mesurer des composants à très hautes fréquences pour lesquels les problèmes de connexion sont parfois limitatifs.

Des solutions existent, qui permettent de pallier en partie à ces inconvénients. Les tests peuvent être réalisés de manière échantillonnée, avec bien sûr un risque sur la fonctionnalité finale de tous les circuits de la plaquette.

Une autre solution consiste à utiliser des cartes à pointes permettant de réaliser une connexion sur plusieurs composants (de deux à quatre puces) de la plaquette. Ceci permet de limiter le temps de déplacement d'un composant au suivant puisqu'un déplacement de la plaquette sous la carte à pointes a plusieurs composants pour objet. Cela peut conduire aussi à réaliser certains tests en parallèle en multipliant les fonctionnalités des appareils de contrôle. Un défaut de cette solution est l'augmentation de complexité et d'élévation du coût des cartes à pointes ainsi que de l'appareil de contrôle. D'autre part, cette technique est limitée et ne progresse pas de la même manière que l'augmentation du nombre de puces par plaquette résultant de l'augmentation de la taille de celle-ci.

Le document FR-A-2 700 063, correspondant au brevet américain N° 5 608 335, divulgue un procédé de test de puces de circuit intégré. Il est prévu, sur la plaquette comprenant les puces à tester, une zone de circuit de test comportant des plots de contact sur lesquels peuvent être appliquées les pointes d'un testeur. La zone de circuit de test comporte en outre un multiplexeur pour diriger les signaux de test vers les différentes puces à contrôler. Le multiplexeur est relié aux différentes puces de la plaquette par des lignes de connexion. Ce procédé ne permet pas de contrôler simultanément toutes les puces de la plaquette, mais il évite les déplacements de la plaquette sous la carte à pointes en réalisant une connexion en un seul endroit de la plaquette. D'autre part, la mise en oeuvre de cette technique est incompatible avec la fabrication actuelle des composants électroniques par photo-répétition. Elle fait appel aux techniques de masquage dit "pleine plaque". Dans le meilleur des cas, elle nécessiterait un mélange des deux techniques.

Le document US-A-5 034 685 divulgue un dispositif de test pour contrôler des circuits intégrés réalisés sur une tranche. Le dispositif comprend :
- un support pour la tranche à tester qui présente des points de contact sur une première face,
- un élément présentant une surface flexible, d'épaisseur inférieure à 15µm et possédant un nombre de points de test correspondant aux points de contact de la tranche, cet élément présentant une surface flexible peut supporter une circuiterie d'interconnexion,
- des moyens pour interconnecter les points de test aux points de contact,
- des moyens pour fournir à ladite surface de l'élément des signaux de contrôle.

Le document US-A-3 848 188 divulgue un système de contrôle à multiplexeur. Le système de contrôle est apte à contrôler une pluralité de dispositifs élémentaires positionnés à une interface de contact. Le système peut contrôler successivement un ensemble de dispositifs disposés en matrice grâce à des groupements de sondes. Pour effectuer un test, les sondes d'un même groupement sont mises en contact électrique avec les contacts d'un dispositif. élémentaire.

### EXPOSÉ DE L'INVENTION

L'invention permet de remédier à ces inconvénients. Elle permet d'effectuer le contrôle simultané de plusieurs ou de tous les dispositifs électroniques réalisés sur une tranche. Cette tranche peut être en silicium, en GaAs, en SiC. Il peut s' agir d'un substrat SOI.

Un premier objet de l'invention consiste en une plaquette de test pour le contrôle de dispositifs microélectroniques réalisés sur une tranche, chaque dispositif microélectronique présentant des entrées/sorties sur une première face de la tranche, dans laquelle :
- la plaquette de test comprend des circuits de contrôle pour le contrôle simultané de la fonctionnalité des dispositifs microélectroniques, la plaquette de test comprenant autant de circuits de contrôle qu'il y a de dispositifs microélectroniques ou de groupes de dispositifs microélectroniques à contrôler;
- une première face de la plaquette de test comporte des moyens de connexion permettant, lorsque la première face de la plaquette de test est positionnés et appliquée sur la première face de la tranche, de connecter les entrées/sorties des dispositifs microélectroniques aux circuits de contrôle de leur fonctionnalité;
- une deuxième face de la plaquette de test comporte des moyens de liaison mécanique à un organe permettant le positionnement et le maintien mécanique de la plaquette de test sur la tranche, et des moyens de connexion permettant, lorsque la première face de la plaquette de test est positionnée et appliquée sur la première face de la tranche, d'assurer une interface vers les circuits de contrôle :
- la plaquette de test comprend des moyens de liaison électrique entre les moyens de connexion de la deuxième face de la plaquette et les circuits de contrôle.

Si chaque circuit de contrôle contrôle un groupe de dispositifs microélectroniques, la plaquette de test peut comprendre également un multiplexeur associé à chaque circuit de contrôle pour contrôler successivement chacun des dispositifs microélectroniques du groupe.

De préférence, les circuits de contrôle sont réalisés sur la première face de la plaquette de test. Les moyens de liaison électrique entre les moyens de connexion de la deuxième face de la plaquette et les circuits de contrôle peuvent alors comprendre des traversées reliant les première et deuxième faces de la plaquette de test.

Les moyens de connexion de la deuxième face de la plaquette de test peuvent comprendre des moyens de connexion électrique et/ou des moyens de connexion optoélectroniques.

Les moyens de connexion de la première face de la plaquette de test peuvent comprendre des plots de connexion.

Avantageusement, les entrées/sorties sur la première face de la tranche étant des plots de connexion, les plots de connexion de la première face de la plaquette de test sont en un matériau plus dur que les plots de connexion des entrées/sorties sur la première face de la tranche.

L'invention a aussi pour objet un appareil de contrôle de dispositifs microélectroniques réalisés sur une tranche, chaque dispositif microélectronique présentant des entrées/sorties sur une première face de la tranche, caractérisé en ce qu'il comprend :
- une plaquette de test telle que décrite ci-dessus,
- un robot possédant des moyens de réception de la tranche et un organe permettant le positionnement et le maintien mécanique de la plaquette de test sur la tranche,
- des moyens d'alimentation électrique et de communication reliés aux moyens de connexion de la deuxième face de la plaquette et destinés à la réalisation du contrôle des dispositifs microélectroniques,
- un micro-ordinateur relié au robot et aux moyens d'alimentation électrique et de communication, permettant de gérer le contrôle des dispositifs microélectroniques.

### BRÈVE DESCRIPTION DES DESSINS

L'invention sera mieux comprise et d'autres avantages et particularités apparaîtront à la lecture de la description qui va suivre, donnée à titre d'exemple non limitatif, accompagnée des dessins annexés parmi lesquels :
- la figure 1 représente un assemblage comprenant la plaquette de test selon l'invention, positionnée et maintenue sur une tranche comportant des dispositifs microélectroniques à contrôler,
- la figure 2 est une vue partielle et en coupe transversale de la plaquette de test positionnée sur la tranche de dispositifs microélectroniques à contrôler,
- la figure 3 est une vue partielle et en perspective d'une plaquette de test utilisable pour la présente invention, cette vue ne montrant qu'un seul circuit de contrôle,
- la figure 4 est une vue partielle et en coupe transversale montrant une interface mécanique appliquée sur la plaquette de test selon l'invention,
- la figure 5 illustre, de manière schématique, un appareil de contrôle de dispositifs microélectroniques selon la présente invention.

### DESCRIPTION DÉTAILLÉE DE MODES DE RÉALISATION DE L'INVENTION

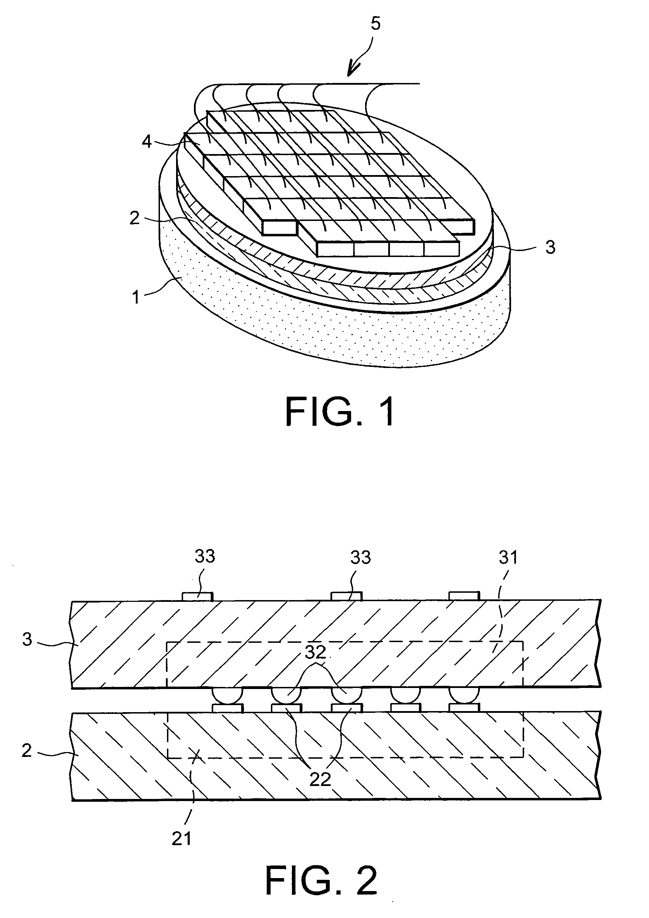

La figure 1 représente un assemblage comprenant la plaquette de test selon l'invention, positionnée et maintenue sur une tranche comportant des dispositifs microélectroniques à contrôler.

L'assemblage comprend, de bas en haut, un support 1 supportant successivement une tranche 2 comportant des dispositifs microélectroniques à contrôler, une plaquette de test 3, un organe 4 permettant le positionnement et le maintien mécanique de la plaquette de test sur la tranche, enfin un bus 5 de liaisons électriques comprenant des fils d'alimentation électrique et des fils de communication électronique.

La plaquette de test 3 est une plaquette en matériau semiconducteur et qui comporte, sur l'une de ses faces, des circuits permettant de contrôler la fonctionnalité des dispositifs de la tranche 2 à contrôler. Les dispositifs à contrôler sont réalisés sur une tranche qui peut être en silicium, en GaAs, en SiC, etc... La fonctionnalité à contrôler est principalement électrique. Elle peut aussi être optique ou mécanique. Les circuits de contrôle intègrent diverses fonctions et nécessitent donc une certaine surface de réalisation. Il se peut que dans certains cas cette surface soit supérieure à la surface des dispositifs à contrôler. Pour ces cas, un circuit de la plaquette de test est utilisé pour contrôler un groupe de dispositifs de la tranche en intégrant des techniques de multiplexage connues.

La plaquette de test a avantageusement la même taille que la tranche à contrôler. Elle comporte autant de circuits qu'il y a de dispositifs ou de groupes de dispositifs à contrôler.

Avantageusement, chaque circuit de contrôle a les mêmes dimensions que le dispositif ou le groupe de dispositifs à contrôler et est situé, sur la plaquette de test, en regard du dispositif ou du groupe de dispositifs à contrôler. Des moyens numériques et/ou analogiques de mesure, qui peuvent être spécifiques à un type ou à une famille de dispositifs, peuvent être associés aux circuits de contrôle.

Les plots d'entrée/sortie d'un dispositif à contrôler, ou d'un groupe de dispositifs à contrôler, se trouvent en contact avec des plots correspondants d'un circuit de contrôle.

La figure 2 est une vue partielle et en coupe transversale de la plaquette de test positionnée sur la tranche de dispositifs microélectroniques à contrôler.

En traits interrompus, on a montré les limites d'un dispositif microélectronique 21 réalisé dans la tranche 2. Le dispositif 21 comporte des plots d'entrée/sortie 22. La plaquette de test 3 est positionnée sur la tranche 2 de façon que les dispositifs à contrôler soient alignés avec leurs circuits de contrôle. Un circuit de contrôle 31 de la plaquette de test 3 est aussi représenté. Il comporte des plots de connexion 32 connectés aux plots d'entrée/sortie 22 appropriés et des plots de connexion 33 pour les liaisons électriques aux fils d'alimentation électrique et pour les fils de communication électronique. Les plots d'entrée/sortie 22 des dispositifs à contrôler sont réalisés en un matériau tendre, par exemple de l'aluminium, et sont plans. Les plots de connexion 32 du circuit de contrôle comportent des nodules d'épaisseur suffisante pour obtenir un contact électrique efficace. Ils sont réalisés avec un matériau plus dur que le matériau des plots des dispositifs à contrôler, par exemple en nickel ou en tungstène, pour éviter leur dégradation à cause d'un emploi répété.

Les plots de connexion 33 situés sur la face supérieure de la plaquette de test 3 comprennent, pour un circuit de contrôle, au moins deux plots de réception d'une tension d'alimentation du circuit de contrôle et du dispositif à contrôler et au moins deux plots pour échanger des signaux de communication avec les autres éléments de l'appareil de contrôle. Ces plots de connexion 33 sont reliés au circuit de contrôle 31 par des lignes conductrices et des traversées conductrices traversant la plaquette 3. Ces lignes et traversées peuvent être réalisées par des techniques microélectroniques connues.

Les circuits de contrôle peuvent être réalisés à partir d'une face d'un substrat semiconducteur servant de plaquette de test. Ils peuvent aussi être rapportés sur une plaquette de matériau isolant tel que le Mylar.

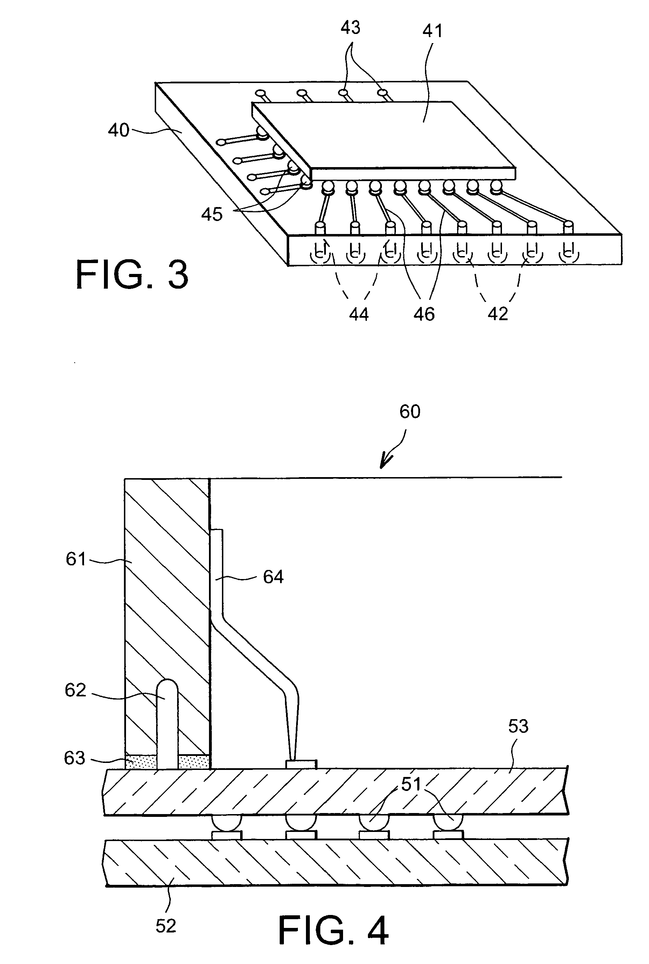

La figure 3 est une vue partielle et en perspective d'une telle plaquette de test, cette vue ne montrant qu'un seul circuit de contrôle.

La plaquette 40 est en un matériau tel que le Mylar. Les circuits de contrôle sont réalisés à part, par exemple sur un substrat de silicium puis découpés. Sur la plaquette 40 sont réalisés différents éléments de conduction électrique. Sur la face inférieure de la plaquette 40, on réalise des plots avec des nodules 42 pour les connexions au dispositif à contrôler. Sur la face supérieure de la plaquette 40, on réalise des plots de connexion 43 pour l'interface électronique, des plots de connexion 45 pour la fixation du circuit de contrôle sur la plaquette et des lignes conductrices 46 pour relier les plots de connexion 45 aux plots de connexion 43 d'interface et, par l'intermédiaire de traversées 44, aux plots de connexion 42. Le circuit de contrôle 41 est ensuite fixé sur la face supérieure de la plaquette 40 par la technique "flip-chip". Tout ceci fait appel à des techniques connues en électronique ou en microélectronique.

La plaquette de test est, lors de son utilisation, positionnée et maintenue au-dessus de la tranche à contrôler par une interface mécanique. Ceci peut être obtenu par des canalisations réalisées à l'intérieur de l'organe servant d'interface mécanique et reliées à une pompe à vide. De ce fait, quand la plaquette de test est disposée sous cette interface mécanique, elle y est maintenue par la technique d'aspiration.

L'interface mécanique a aussi pour rôle de supporter des pointes conductrices de l'interface électronique, prenant contact avec les plots de connexion de la face supérieure de la plaquette de test pour chaque circuit de contrôle. L'interface mécanique peut supporter des liaisons optiques dans le cas de moyens de communication optoélectronique.

La figure 4 est une vue partielle et en coupe transversale montrant une interface mécanique appliquée sur la plaquette de test selon l'invention. On reconnaît la plaquette de test 53 avec ses nodules de contact 51 positionnée sur la tranche à contrôler 52 et maintenue dans cette position par l'organe 60 servant d'interface mécanique. La face de la paroi 61 de l'organe 60 qui est adjacente à la plaquette de test 53 est pourvue d'une canalisation 62 pour le vide d'aspiration. Cette face est revêtue d'un matériau souple 63 pour assurer l'étanchéité. Sur la paroi 61 a été représentée une pointe conductrice 64 prenant contact avec un plot de connexion de la face supérieure de la plaquette de test 53.

L'organe servant d'interface mécanique peut avoir une forme alvéolée. Les armatures des alvéoles sont alors positionnées au-dessus des plots de connexion de la plaquette de test. Elles favorisent ainsi la pression pour obtenir un contact efficace.

Le robot de l'appareil de contrôle selon l'invention nécessite une surface de manipulation de la tranche à contrôler équivalente à la taille de celle-ci. Il possède les fonctions suivantes :
- chargement de la plaquette de test sur le support du robot,
- alignement de la plaquette de test par rapport à l'interface mécanique (par exemple en alignant les plots de la face supérieure de la plaquette par rapport aux pointes fixées sur l'interface mécanique),
- fixation de la plaquette de test sous l'interface mécanique par aspiration,
- chargement d'une première tranche à tester sur le support du robot,
- alignement de la tranche par rapport à la plaquette de test de manière que tous les plots de tous les dispositifs à tester soient en face de tous les plots de tous les circuits de contrôle,
- mise en contact,
- réalisation du contrôle,
- déchargement de la tranche contrôlée,
- chargement de la tranche à contrôler suivante.

L'interface électronique permet de connecter la plaquette de test aux sources d'alimentation en tension et/ou en courant pour tous les circuits de contrôle de la plaquette de test et des dispositifs à contrôler sur la tranche. L'interface électronique possède des moyens de communication avec tous les circuits de la plaquette de test, par exemple des interfaces dites séries ou des interfaces dites optoélectroniques. Elle possède des fils de liaison connectés aux pointes placées sur l'interface mécanique. Elle est reliée au micro-ordinateur qui gère l'ensemble des tests pour lui fournir les résultats des tests de tous les dispositifs microélectroniques.

Chaque circuit de contrôle de la plaquette de test est constitué d'un circuit intégré spécifique. Il comporte, pour réaliser le test du dispositif à tester :
- des moyens de mesures électriques numériques et/ou analogiques,
- des moyens de multiplexage pour connecter ces moyens de mesures aux différentes entrées/sorties du dispositif à contrôler,
- une mémoire où sont stockés la séquence de test, les résultats des tests, les facteurs d'ajustage des moyens de mesures, les informations relatives à ce circuit de contrôle (plaque, numéro du circuit, etc..,
- un processeur chargé de réaliser la séquence de tests,
- une interface de communication électronique ou optoélectronique pour transférer les résultats des tests à l'interface électronique.

Chaque circuit de contrôle de la plaquette de test est après sa fabrication contrôlé, à l'aide d'un système de test classique, de manière à vérifier son fonctionnement et à étalonner ses moyens de mesures numériques et/ou analogiques. Ensuite, peuvent être stockés dans sa mémoire les informations relatives à ce circuit de contrôle (numéro de plaque, numéro de circuit...) et les facteurs d'ajustage des moyens de mesures.

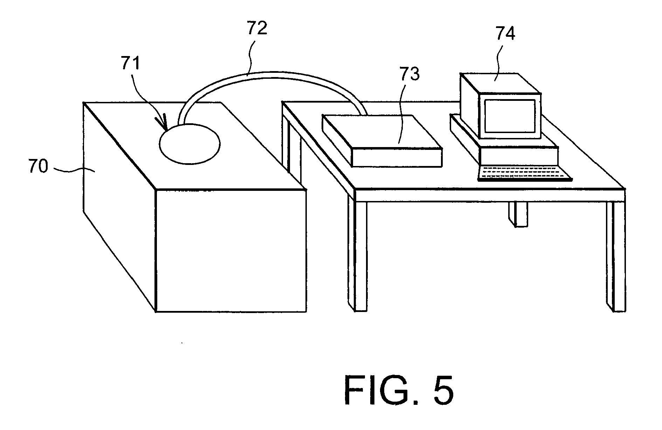

La figure 5 illustre, de manière schématique, un appareil de contrôle de dispositifs microélectroniques selon la présente invention.

L'appareil de contrôle comprend un robot 70 de dimensions très réduites par rapport aux robots des appareils de contrôle de l'art antérieur. Ce robot n'est chargé que de manipuler les tranches à contrôler pour les placer successivement sous la plaquette de test. L'assemblage constitué d'un support, de la tranche à contrôler, de la plaquette de test, de l'organe de positionnement et de maintien mécanique de la plaquette de test sur la tranche et de l'interface électronique (voir la figure 1) est représenté symboliquement sous la référence 71. Un bus de liaisons électriques 72 relie la plaquette de test à un dispositif 73 comprenant notamment les sources d'alimentation électriques et qui est relié au micro-ordinateur 74 qui gère l'ensemble des tests.

## Revendications

1. Plaquette de test (3, 40, 53) pour le contrôle de dispositifs microélectroniques réalisés sur une tranche (2,52), chaque dispositif microélectronique (21) présentant des entrées/sorties sur une première face de la tranche, une première face de la plaquette de test (3) comportant des moyens de connexion (32) permettant, lorsque la première face de la plaquette de test (3) est positionnée et appliquée sur la première face de la tranche (2), de connecter les entrées/sorties (22) des dispositifs microélectroniques à des circuits de contrôle de leur fonctionnalité, une deuxième face de la plaquette de test (3) comportant des moyens de liaison mécanique à un organe (4) permettant le positionnement et le maintien mécanique de la plaquette de test sur la tranche (2), et des moyens de connexion permettant, lorsque la première face de la plaquette de test est positionnée et appliquée sur la première face dé la tranche, d'assurer une interface vers les circuits de contrôle, la plaquette de test (3) comprenant des moyens de liaison électrique entre les moyens de connexion de la deuxième face de la plaquette et les circuits de contrôle,
**caractérisée en ce que**
la plaquette de test (3) comprend les circuits de contrôle (31) qui contrôlent de manière simultanée la fonctionnalité des dispositifs microélectroniques (21), la plaquette de test comprenant autant de circuits de contrôle qu'il y a de dispositifs microélectroniques ou de groupes de dispositifs microélectroniques à contrôler.

2. Plaquette de test selon la revendication 1, **caractérisée en ce que**, chaque circuit de contrôle contrôlant un groupe de dispositifs microélectroniques, la plaquette de test comprend également un multiplexeur associé à chaque circuit de contrôle pour contrôler successivement chacun des dispositifs microélectroniques du groupe.

3. Plaquette de test selon l'une des revendications 1 ou 2, **caractérisée en ce que** les circuits de contrôle (31) sont réalisés sur la première face de la plaquette de test (3).

4. Plaquette de test selon la revendication 3, **caractérisée en ce que** les moyens de liaison électrique entre les moyens de connexion de la deuxième face de la plaquette et les circuits de contrôle comprennent des traversées reliant les première et deuxième faces de la plaquette de test.

5. Plaquette de test selon l'une quelconque des revendications 1 à 4, **caractérisée en ce que** les moyens de connexion de la deuxième face de la plaquette de test comprennent des moyens de connexion électrique et/ou des moyens de connexion optoélectroniques.

6. Plaquette de test selon l'une quelconque des revendications 1 à 5, **caractérisée en ce que** les moyens de connexion de la première face de la plaquette de test (3) comprennent des plots de connexion (32).

7. Plaquette de test selon la revendication 6, **caractérisée en ce que** les entrées/sorties (22) sur la première face de la tranche (21) étant des plots de connexion, les plots de connexion (32) de la première face de la plaquette de test (3) sont en un matériau plus dur que les plots de connexion des entrées/sorties sur la première face de la tranche.

8. Appareil de contrôle de dispositifs microélectroniques réalisés sur une tranche, chaque dispositif microélectronique présentant des entrées/sorties sur une première face de la tranche, **caractérisé en ce qu'**il comprend :
- une plaquette de test selon l'une quelconque des revendications 1 à 7,
- un robot (70) possédant des moyens de réception de la tranche et un organe permettant le positionnement et le maintien mécanique de la plaquette de test sur la tranche,
- des moyens d'alimentation électrique (73) et de communication reliés aux moyens, de connexion de la deuxième face de la plaquette de test et destinés à la réalisation du contrôle des dispositifs microélectroniques,
- un micro-ordinateur (74) relié au robot et aux moyens d'alimentation électrique et de communication, permettant de gérer le contrôle des dispositifs microélectroniques.

## Claims

1. Contacting piece (3, 40 and 53) for the inspection of microelectronic devices formed on a wafer (2 and 52), each microelectronic device (21) having inputs/outputs on a first face of the wafer, a first face of the contacting piece (3) comprising means of connection (32) with which - when the first face of the contacting piece (3) is positioned and applied to the first face of the wafer (2) - the inputs/outputs (22) of the microelectronic devices can be connected to circuits for inspecting their functionality, a second face of the contacting piece (3) comprising means of mechanical connection to an element (4) with which the contacting piece can be positioned and mechanically held on the wafer (2) and connection means with which - when the first face of the contacting piece is positioned and applied to the first face of the wafer - an interface to the inspection circuits can be provided, the contacting piece (3) comprising means of electrical connection between the means of connection of the second face of the piece and the inspection circuits, **characterized in that**
the contacting piece (3) comprises the inspection circuits (31) which simultaneously inspect the functionality of the microelectronic devices (21), the contacting piece comprising as many inspection circuits as there are microelectronic devices or groups of microelectronic devices to be inspected.

2. Contacting piece according to claim 1, **characterized in that**, each inspection circuit inspecting a group of microelectronic devices, the contacting piece also comprises a multiplexer associated with each inspection circuit in order to inspect successively each of the microelectronic devices in the group.

3. Contacting piece according to either of claims 1 or 2, **characterized in that** the inspection circuits (31) are formed on the first face of the contacting piece (3).

4. Contacting piece according to claim 3, **characterized in that** the means of electrical connection between the means of connection of the second face of the piece and the inspection circuits comprise crossings linking the first and second faces of the contacting piece.

5. Contacting piece according to any of claims 1 to 4, **characterized in that** the means of connection of the second face of the contacting piece comprise means of electrical connection and/or optoelectronic connection means.

6. Contacting piece according to any of claims 1 to 5, **characterized in that** the means of connection of the first face of the contacting piece (3) comprise connection studs (32).

7. Contacting piece according to claim 6, **characterized in that** the inputs/outputs (22) on the first face of the wafer (21) being connection studs, the connection studs (32) of the first face of the contacting piece (3) are made of a harder material than the connection studs of the inputs/outputs on the first face of the wafer.

8. Device for inspection of microelectronic devices formed on a wafer, each microelectronic device having inputs/outputs on a first face of the wafer, **characterized in that** it comprises:
- a contacting piece according to any of claims 1 to 7,
- a robot (70) having means of receiving the wafer and an element with which the contacting piece can be positioned and mechanically held on the wafer,
- means of electrical supply (73) and of communication linked to the means of connection of the second face of the contacting piece and intended for carrying out the inspection of the microelectronic devices and
- a microcomputer (74) linked to the robot and to the means of electrical supply and communication, with which the inspection of the microelectronic devices can be managed.

## Patentansprüche

1. Testscheibe (3, 40, 53) zur Kontrolle der auf einem Wafer (2, 52) realisierten mikroelektronischen Vorrichtungen, wobei jede mikroelektronische Vorrichtung (21) auf einer ersten Seite des Wafers Eingänge/Ausgänge aufweist, eine erste Seite der Testscheibe (3) Verbindungseinrichtungen (32) umfasst, die ermöglichen, wenn die erste Seite der Testscheibe (3) auf der ersten Seite des Wafers (2) positioniert und angebracht ist, die Eingänge/Ausgänge (22) der mikroelektronischen Vorrichtungen mit Schaltkreisen zur Kontrolle ihrer Funktionalität zu verbinden, und eine zweite Seite der Testscheibe (3) mechanische Verbindungseinrichtungen mit einem die Positionierung und den mechanischen Halt der Testscheibe auf dem Wafer (2) gewährleisteten Organ (4) sowie Anschlusseinrichtungen umfasst, die ermöglichen - wenn die erste Seite der Testscheibe auf der ersten Seite des Wafers positioniert und angebracht ist -, eine Schnittstelle zu den Kontrollschaltkreisen zu bilden, wobei die Testscheibe (3) elektrische Verbindungseinrichtungen zwischen den Anschlusseinrichtungen der zweiten Seite der Scheibe und den Kontrollschaltkreisen umfasst,
**dadurch gekennzeichnet, dass**
die Testscheibe (3) die Kontrollschaltkreise (31) umfasst, die simultan die Funktionalität der mikroelektronischen Vorrichtungen (21) kontrollieren, wobei die Testscheibe ebenso viele Kontrollschaltkreise umfasst, wie es zu kontrollierende mikroelektronische Vorrichtungen oder Gruppen von mikroelektronischen Vorrichtungen gibt.

2. Testscheibe nach Anspruch 1, **dadurch gekennzeichnet, dass** jeder Kontrollschaltkreis eine Gruppe von mikroelektronischen Vorrichtungen kontrolliert, wobei die Testscheibe auch einen mit jedem Kontrollschaltkreis verbundenen Multiplexer umfasst, zur sukzessiven Kontrolle von jeder der mikroelektronischen Vorrichtungen der Gruppe.

3. Testscheibe nach einem der Ansprüche 1 oder 2, **dadurch gekennzeichnet, dass** die Kontrollschaltkreise (31) auf der ersten Seite der Testscheibe (3) verbunden sind.

4. Testscheibe nach Anspruch 3, **dadurch gekennzeichnet, dass** die elektrischen Verbindungseinrichtungen zwischen den Anschlusseinrichtungen der zweiten Seite der Scheibe und den Kontrollschaltkreisen Durchquerungen umfassen, welche die erste und die zweite Seite der Testscheibe verbinden.

5. Testscheibe nach einem der Ansprüche 1 bis 4, **dadurch gekennzeichnet, dass** die Anschlusseinrichtungen der zweiten Seite der Testscheibe elektrische Verbindungseinrichtungen und/oder optoelektronische Verbindungseinrichtungen umfassen.

6. Testscheibe nach einem der Ansprüche 1 bis 5, **dadurch gekennzeichnet, dass** die Anschlusseinrichtungen der ersten Seite der Testscheibe (3) Anschlussstützpunkte (32) umfassen.

7. Testscheibe nach Anspruch 6, **dadurch gekennzeichnet, dass** die Eingänge/Ausgänge (22) auf der ersten Seite des Wafers (21) Anschlussstützpunkte sind, wobei die Anschlussstützpunkte (32) der ersten Seite der Testscheibe (3) aus einem Material sind, das härter ist als die Anschlussstützpunkte der Eingänge/Ausgänge auf der ersten Seite des Wafers.

8. Kontrollgerät von mikroelektronischen Vorrichtungen, realisiert auf einem Wafer, wobei jede mikroelektronische Vorrichtung Eingänge/Ausgänge auf einer ersten Seite des Wafers aufweist, **dadurch gekennzeichnet, dass** es umfasst:
- eine Testscheibe nach einem der Ansprüche 1 bis 7,
- einen Roboter (70) mit Aufnahmeeinrichtungen für den Wafer und ein die Positionierung und den mechanischen Halt der Testscheibe auf dem Wafer ermöglichendes Organ,
- Stromversorgungs- und Kommunikationseinrichtungen (73), verbunden mit den Anschlusseinrichtungen der zweiten Seite der Testscheibe und bestimmt zur Durchführung der Kontrolle der mikroelektronischen Vorrichtungen,
- ein Mikrocomputer (74), verbunden mit dem Roboter und den Stromversorgungs- und Kommunikationseinrichtungen, der ermöglicht, die Kontrolle der mikroelektronischen Vorrichtungen zu steuern.
